Europäisches Patentamt

European Patent Office

Office européen des brevets

(19)

(11) Publication number: **0 036 246**
**B1**

(12) # EUROPEAN PATENT SPECIFICATION

(45) Date of publication of patent specification: **08.08.84**

(21) Application number: **81300597.2**

(22) Date of filing: **13.02.81**

(51) Int. Cl.³: **G 11 C 11/24, G 05 F 3/20, G 11 C 7/00**

(54) Semiconductor memory device with substrate voltage biasing.

(30) Priority: **16.02.80 JP 18358/80**

(43) Date of publication of application:
**23.09.81 Bulletin 81/38**

(45) Publication of the grant of the patent:
**08.08.84 Bulletin 84/32**

(84) Designated Contracting States:
**DE FR GB NL**

(56) References cited:
**WO - A - 80/01021
WO - A - 80/02773
DE - A - 2 420 877
FR - A - 2 235 417
US - A - 4 030 084
US - A - 4 115 710**

**IEEE INTERNATIONAL SOLID-STATE CIRCUITS
CONFERENCE, 13 February 1980, New York,
USA GRAHAM et al. "Battery back-up circuits for
memories", pages 58-59**

(73) Proprietor: **FUJITSU LIMITED
1015, Kamikodanaka Nakahara-ku
Kawasaki-shi Kanagawa 211 (JP)**

(72) Inventor: **Takemae, Yoshihiro
20-5-9-301, Utsukushigaoka 1-chome
Midori-ku Yokohama-shi Kanagawa 227 (JP)**
Inventor: **Baba, Fumio
3-12-204, Sakonyama
Asahi-ku Yokohama-shi Kanagawa 241 (JP)**

(74) Representative: **George, Sidney Arthur et al,
GILL JENNINGS & EVERY 53-64 Chancery Lane
London WC2A 1HN (GB)**

(56) References cited:
**IEEE JOURNAL OF SOLID-STATE CIRCUITS, vol.
SC 15, no. 5, October 1980, New York, US
MARTINO et al. "An on-chip backbias generator
for MOS dynamic memory", pages 820-826
IEEE INTERNATIONAL SOLID-STATE CIRCUITS
CONFERENCE, 15 February 1979, Digest of
Technical Papers, New York, US LEE et al. "A
80ns 5V-only dynamic RAM", pages 142-143**

Courier Press, Leamington Spa, England.

**TRANSACTIONS OF THE IECE OF JAPAN, vol. E63, no. 7, July 1980, Tokyo, JP MORIMOTO et al. "High speed DSA 4Kbit static RAM", pages 520-525**

**INTEL MEMORY DESIGN HANDBOOK, 1975, Santa Clara, US OLIPHANT "Designing memory systems with the intel 2107A 4K RAM", pages 3-i,3-1 & 3-15**

## Description

This invention relates to a semiconductor memory device provided with a noise canceller for a substrate bias voltage.

In a known technique, a bulk bias voltage is applied to a substrate of semiconductor summory device from outside, and since this voltage is stabilised, for example by a capacitor, any variation of the voltage is not caused by circuit operation in the memory device. Recently, a method in which a bulk bias voltage is generated on the substrate has been adopted in the art. In this method, since it is necessary to perform the operation with reduced power consumption, the current must be reduced and a high impedance cannot be avoided in a bulk bias voltage-generating circuit. Most of the circuit elements are connected to the substrate through capacitances such as PN junctions. Accordingly, when the memory circuit is actuated and voltages at respective parts are changed, noise is fed to the substrate through such capacitances. Therefore, in the case where a bulk bias voltage is internally generated, this voltage varies according to the operation of the memory circuit. Furthermore, since a high impedance is maintained in the bulk bias voltage-generating circuit, variations of the bulk voltage by noise cannot be absorbed or compensated in the bulk bias voltage-generating circuit. For example, variations of 1 to 2 volts can take place in a bulk bias voltage of 4 volts. Such variation of the bulk bias voltage often results in changes in the threshold voltage of a transistor or variations in voltage at respective parts through PN junctions or the like, and it often happens that the circuit operation becomes unstable and operational errors are caused.

It an object of the present invention to provide a semiconductor memory device in which the above defects of the conventional technique are eliminated.

According to the present invention, a semiconductor memory device comprises a semiconductor substrate, a sense amplifier, a pair of bit lines connected to the sense amplifier, memory cells connected to the pair of bit lines, and a bias voltage generator to apply a predetermined bias voltage to the semiconductor substrate, wherein a reading operation is performed by amplifying via the sense amplifier a voltage difference produced between the pair of bit lines due to accessing one of the memory cells, the semi-conductor memory device being characterised in that a voltage having a phase which is the reverse of that of variations in the bias voltage which originate from normal operation of the semiconductor memory device is applied to the substrate via a capacitance.

An embodiment of the invention will now be described, by way of example, with reference to the accompanying drawings, in which:

Fig. 1A is a block diagram illustrating a conventional semiconductor memory device,

Fig. 1B is a partial sectional view showing a substrate of the device of Fig. 1A,

Fig. 2A is a block diagram showing a bulk bias generator circuit in the semiconductor memory device of Fig. 1A,

Fig. 2B is a diagram illustrating waveforms occurring in the circuit of Fig. 2A,

Fig. 3 is a block diagram illustrating a semiconductor memory device according to the present invention,

Fig. 4A is a block diagram showing a bulk bias generator circuit and noise compensator circuit in the semiconductor memory device according to the present invention,

Fig. 4B is a diagram illustrating waveforms occurring in the circuits shown in Fig. 4A,

Fig. 5 is a block diagram illustrating one form of noise compensator circuit, and

Fig. 6 is a sectional view showing one form of electrostatic capacitance connecting the noise compensator circuit to the substrate in the present invention.

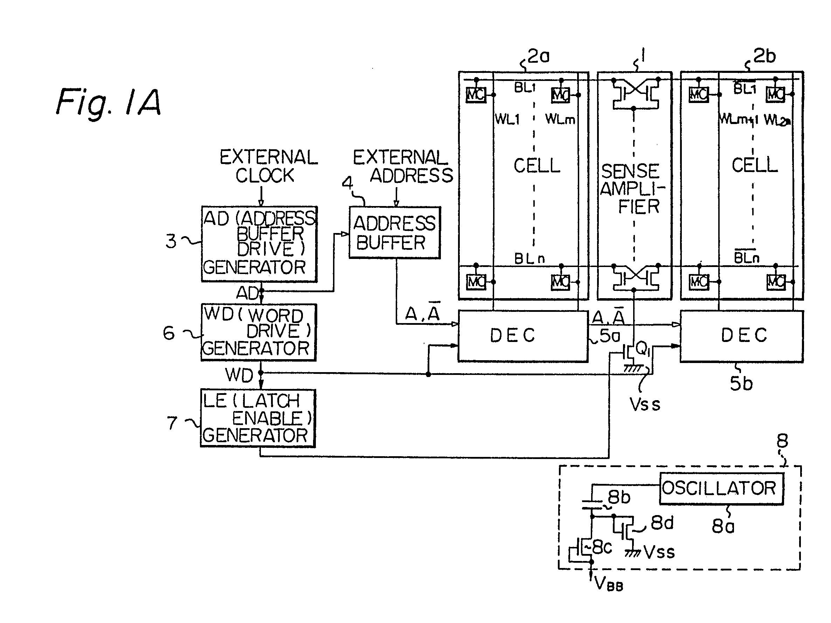

Referring to the drawings, Fig. 1A illustrates a conventional semiconductor memory device fabricated on a semiconductor substrate. This memory device comprises a sense amplifier 1, paired bit lines BL1 and $\overline{BL1}$, ... BLn and $\overline{BLn}$, word lines WL1 to WLm and WLm+1 to WL2m, and cells 2a and 2b having memory cells MC, which are formed between the bit and word lines An AD (address buffer drive) generator 3 receives an external clock signal and outputs an AD signal which is fed to an address buffer 4. On the basis of an external address applied to the address buffer 4, A and $\overline{A}$ are decided and are fed to decoders 5a and 5b. Simultaneously, the output of the AD generator 3 is applied to a WD (word drive) generator 6 and the WD generator 6 outputs a WD signal. This signal is fed to the decoders 5a and 5b to select a word line. The WD signal is applied to an LE (latch enable) generator 7, and in response to an LE signal produced by the LE generator 7 a transistor Q1 is switched-on to actuate a flipflop of the sense amplifier 1 to read out information stored in the memory cell. This semiconductor memory device has a bulk bias generator 8, which comprises an oscillator 8a, a capacitor 8b and transistors 8c and 8d to generate a bulk bias voltage Vbb.

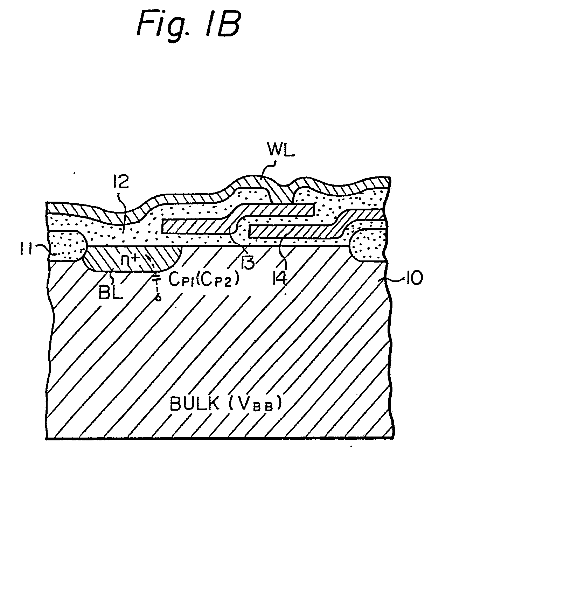

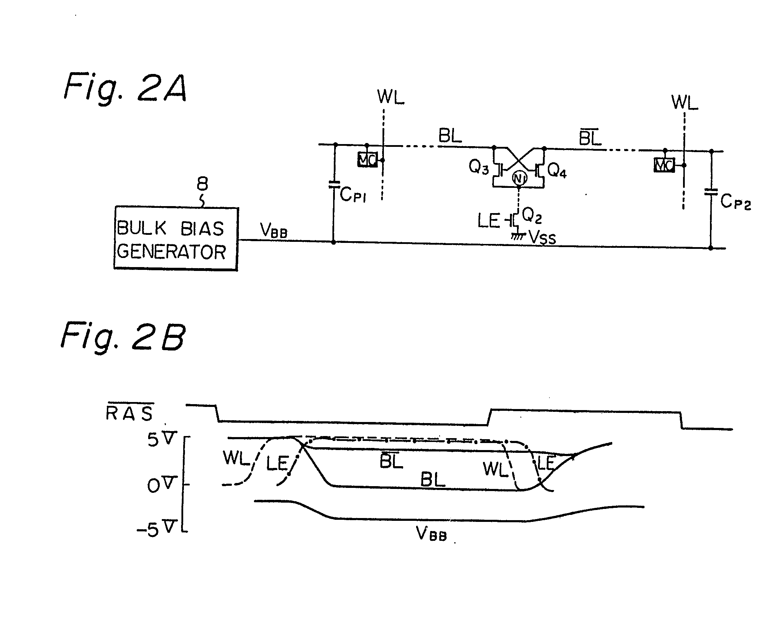

Fig. 1B shows the interrelation between word lines WL and bit lines BL in the semiconductor substrate device shown in Fig. 1A. The device comprises a substrate 10, insulating films 11 and 12 and polysilicon layers 13 and 14. The polysilicon layers 13 and 14 are disposed to form the memory cells MC shown in Fig. 1A. When the bulk bias voltage Vbb is generated on the substrate as in the semiconductor memory device shown in Fig. 1A, the main element which influences the bulk bias voltage Vbb is the bit line BL. As is well-known, the bit line is fabricated by forming, for example, a diffusion layer on the semiconductor substrate, and hence a PN junction is formed. Accordingly, an electrostatic capacitance Cp1 (Cp2) is formed between the bit line and the substrate by a depletion layer of the PN junction. When the voltage on the bit line is changed, the bulk bias voltage Vbb changes via this electrostatic capacitance according to the change in the bit line voltage. This state will now be described with reference to Figs. 2A and 2B.

Fig. 2A shows an interrelation between the electrostatic capacitance Cp1 which is present between one bit line and the bulk bias voltage generator 8 and the electrostatic capacitance Cp2 which is present between the bit line and the substrate in the semiconductor memory device shown in Fig. 1A. Fig. 2B illustrates the relationship between an external clock pulse $\overline{RAS}$, a signal WL applied to the word line, a signal LE driving the flipflop of the sense amplifier, potentials of bit lines BL and $\overline{BL}$ driven to low and high levels by the flipflop of the sense amplifier, and a bulk bias signal Vbb. In Fig. 2B, it is shown that variations of 1 to 2 volts are caused in the bulk bias signal.

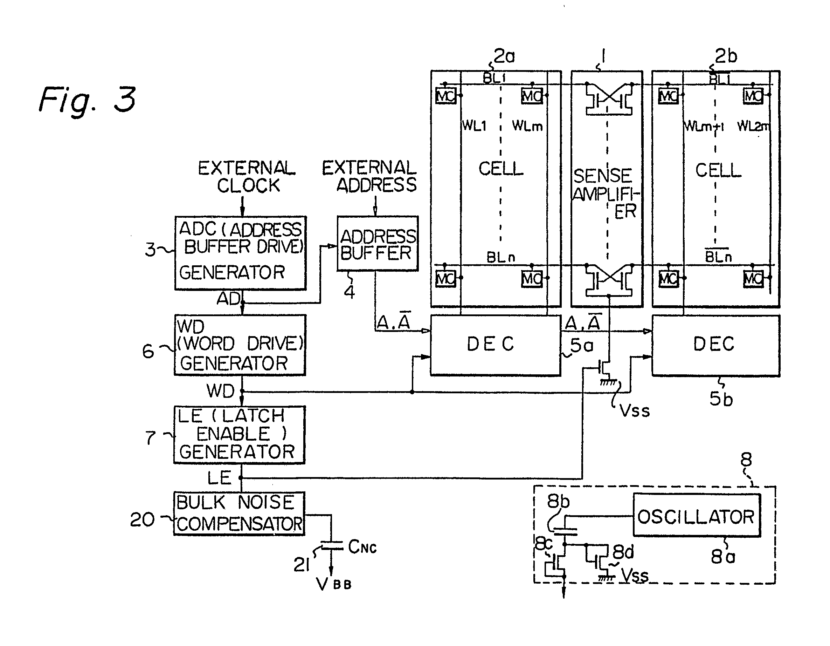

Fig. 3 illustrates one embodiment of a semiconductor memory device according to the present invention. As is shown in Fig. 3, in the present invention a bulk noise compensator 20 is formed at the output of the LE generator 7 to generate on the output thereof a signal NC of reverse phase to that of the noise on the bulk bias signal Vbb. If this signal NC is applied to the bulk bias signal Vbb via a capacitor 21, the noise is cancelled. The capacitor 21 is fabricated by an MOS diode comprising polysilicon, silicon oxide film and silicon substrate so that the capacitance of the capacitor 21 is substantially equal to the capacitance between the bit line and the substrate.

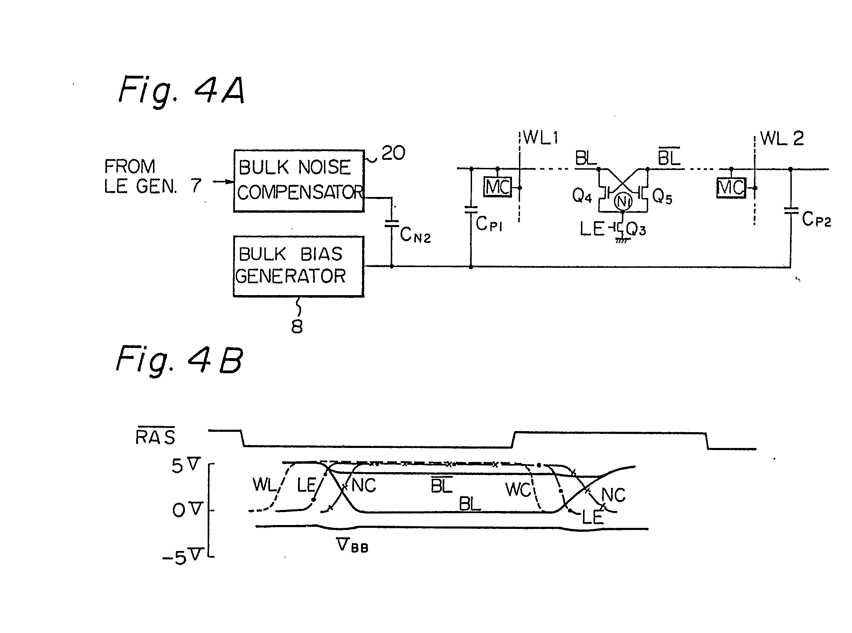

Fig. 4A is a block illustrating a circuit in which the substrate noise compensator 20 is formed in the circuit of Fig. 2A and the signal from the noise compensator 20 is applied as a bulk bias compensating signal via the capacitor 21 (Cnc). Fig. 4B illustrates the stage in which when the bulk bias compensating signal NC is applied, changes in the voltage of the bit line are cancelled by changes in the voltage of this compensating signal NC. Namely, Fig. 4B shows that the bit line $\overline{BL}$ is maintained at a high level whilst the bit line BL is maintained at a low level. In Fig. 4B, $\overline{RAS}$ represents a clock signal. When the voltage of the bit line BL is changed to a low level, a signal Vnc having a level NC and a phase which is the reverse to that of the voltage level of the bit line is generated, based on the clock signal $\overline{RAS}$, to cancel the noise, and the signal Vnc of reverse phase to that of the noise is fed to the substrate via the capacitor 21.

Since the influences of variations of the voltage level on the bit line BL on the bulk bias voltage are thus cancelled by the signal NC, the bulk bias signal Vbb becomes a smooth signal hardly influenced by variations in the voltage level of the bit line BL.

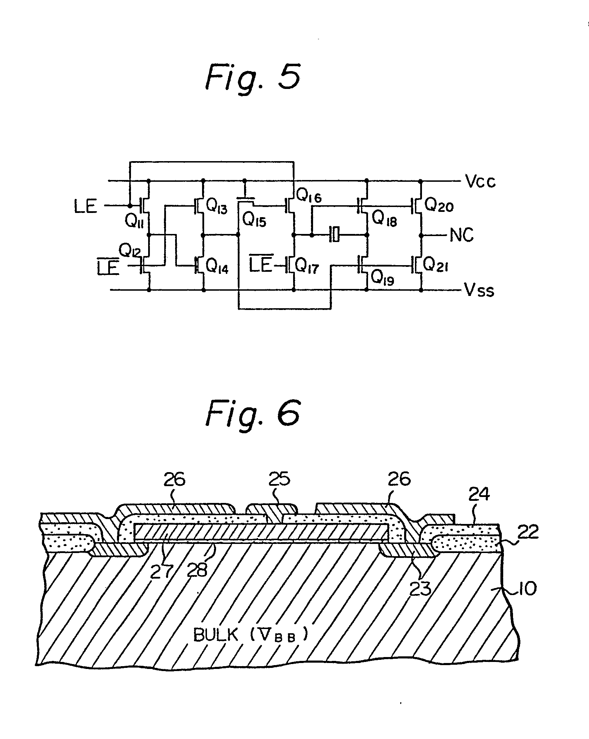

Fig. 5 illustrates one embodiment of the bulk noise compensator 20, which comprises transistors Q11 to Q22. In the embodiment shown in Fig. 5, transistors Q11 to Q14 form a delay circuit, transistors Q15 to Q19 form a bootstrap circuit, and transistors Q20 and Q21 form an output transistor circuit.

Fig. 6 is a sectional view illustrating the condition in which a capacitor Cnc is formed between the bulk noise compensator 20 and the substrate. In Fig. 6, the device comprises a substrate 10, an insulating film 22, an $N^+$ layer 23, an insulating film 24, an aluminium layer 25, an aluminium layer 26, a polysilicon layer 27 and a gate oxide film 28. The output of the bulk noise compensator 20 is connected to the aluminium layer 25, and the gate oxide film 28, located between the polysilicon layer 27 and the substrate 10, acts as the capacitance Cnc to the substrate 10. The output of the bulk bias generator 8 is applied to the aluminium layer 26.

Bit lines can also be formed by forming an oxide film on the silicon substrate and depositing aluminium or polysilicon on this oxide film. In this embodiment, an electrostatic capacitance is formed between the bit line and the substrate as in the foregoing embodiment, and noise is fed to the bulk bias voltage by variations of the signal level on the bit line. However, the noise can similary be cancelled by the arrangement illustrated in the above embodiment. A capacitor Cnc may also be formed by utilising a PN junction. Noise is fed to the bulk bias voltage also from decoders and other circuits. In the present invention, influence of the noises on the bulk bias voltage can be cancelled by the arrangement illustrated in the above embodiment.

The present invention therefore provides a semiconductor memory device with a noise canceller for the bulk bias voltage, so that a stable bulk bias voltage can be obtained.

## Claims

1. A semiconductor memory device comprising a semiconductor substrate (10), a sense amplifier (1), a pair of bit lines (BL) connected to the sense amplifier, memory cells (MC) connected to the pair of bit lines and a bias voltage generator to apply a predetermined bias voltage (VBB) to the semiconductor substrate, wherein a reading operation is performed by amplifying via the sense amplifier a voltage difference produced between the pair of bit lines due to accessing one of the memory cells, the semiconductor memory device being characterised in that a voltage (VNC) having a phase which is the reverse of that of variations in the bias voltage (VBB) which originate from normal operation of the semiconductor memory device is applied to the substrate via a capacitance (21).

2. A memory device as claimed in Claim 1, wherein the voltage of reverse phase to that of variations in the bias voltage (VBB) cancels variations in the voltage of the semiconductor substrate (10) which are due to variations in the voltage of the bit lines (BL) caused when the voltage difference is amplified by the sense amplifier (1) during the reading operation.

## Patentansprüche

1. Halbleiterspeicheranordnung, mit einem Halbleitersubstrat (10), einem Leseverstärker (1), einem Paar von Bitleitungen (BL), die mit dem Leseverstärker verbunden sind, Speicherzellen (MC), die mit dem Paar von Bitleitungen und einem Vorspannungsgenerator verbunden sind, welcher dem Halbleitersubstrat eine vorbestimmte Vorspannung (VBB) zuführt, bei welcher ein Lesebetrieb durchgeführt wird, indem über den Leseverstärker eine Spannungsdifferenz verstärkt wird, welche aufgrund des Zugriffs zu einer der Speicherzellen zwischen dem Paar von Bitleitungen erzeugt wird, dadurch gekennzeichnet, daß eine Spannung (VNC), deren Phase umgekehrt zu derjenigen von Variationen in der Vorspannung (VBB), welche von dem normalen Betrieb der Halbleiterspeicheranordnung herrühren, ist, dem Substrat über eine Kapazität (21) zugeführt wird.

2. Speicheranordnung nach Anspruch 1, bei welcher die Spannung mit der zu den Variationen der Vorspannung (VBB) umgekehrten Phase Variationen in der Spannung des Halbleitersubstrats (10) löschen, welche aufgrund von Variationen in der Spannung der Bitleitungen (BL) beruhen, die verursacht werden, wenn die Spannungsdifferenz während des Lesebetriebs durch den Leseverstärker verstärkt wird.

## Revendications

1. Dispositif de mémoire à semiconducteurs, comprenant un substrat semiconducteur (10), un amplificateur de lecture (1), une paire de lignes de bit (BL) connectées à l'amplificateur de lecture, des cellules de mémoire (MC) connectées à la paire de lignes de bit, et un générateur de tension de polarisation servant à appliquer une tension de polarisation prédéterminée (VBB) au substrat semiconducteur, où une opération de lecture est effectuée par amplification, via l'amplificateur de lecture, d'une différence de tension produite entre la paire de lignes de bit par suite de l'accession à l'une des cellules de mémoire le dispositif de mémoire à semiconducteurs étant caractérisé en ce qu'une tension (VNC) possédant une phase qui est l'inverse de celle des variations de la tension de polarisation (VBB) ayant leur origine dans le fonctionnement normal du dispositif de mémoire à semiconducteurs est appliquée au substrat via une capacité (21).

2. Dispositif de mémoire selon la revendication 1, où la tension possédant une phase inverse à celle des variations de la tension de polarisation (VBB) annule les variations de la tension du substrat semiconducteur (10) qui sont dues à des variations de la tension présente sur les lignes de bit (BL) produites lorsque la différence de tension est amplifiée par l'amplificateur de lecture (1) pendant l'opération de lecture.

Fig. 1A

*Fig. 1B*

*Fig. 2A*

WL  WL

BL  $\overline{BL}$

MC  $Q_3$  N  $Q_4$  MC

8

$C_{P1}$  $C_{P2}$

BULK BIAS GENERATOR

$V_{BB}$

LE  $Q_2$

$V_{SS}$

*Fig. 2B*

$\overline{RAS}$

5V

WL  LE  $\overline{BL}$  WL  LE

0V  BL

-5V

$V_{BB}$

Fig. 3

0 036 246

## Fig. 4A

FROM
LE GEN. 7 →

| BULK NOISE COMPENSATOR | ~20 |

| BULK BIAS GENERATOR |

8

$C_{N2}$

$C_{PI}$

MC

WL1

BL          $\overline{BL}$

$Q_4$   (N1)   $Q_5$

LE $Q_3$

MC

WL 2

$C_{P2}$

## Fig. 4B

$\overline{RAS}$

5∇

0∇

-5∇

WL    LE    NC        $\overline{BL}$    WC        NC

BL                LE

∇$_{BB}$

# Fig. 5

LE —[ $Q_{11}$

$Q_{12}$
$\overline{LE}$—[

$Q_{13}$

$Q_{14}$

$Q_{15}$

$\overline{LE}$—[ $Q_{17}$

$Q_{16}$

$Q_{18}$

$Q_{19}$

$Q_{20}$

$Q_{21}$

Vcc

NC

Vss

# Fig. 6

26    25    26    24    22

27  28    23    10

BULK $(\nabla_{BB})$